(19) Europäisches Patentamt
European Patent Office
Office européen des brevets

(11) **EP 3 498 892 A1**

(12) **DEMANDE DE BREVET EUROPEEN**

(43) Date de publication:
**19.06.2019 Bulletin 2019/25**

(51) Int Cl.:
**C30B 29/06** (2006.01)  **C30B 33/04** (2006.01)
**H01L 21/322** (2006.01)

(21) Numéro de dépôt: **18209997.8**

(22) Date de dépôt: **04.12.2018**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **12.12.2017 FR 1762010**

(71) Demandeur: **Commissariat à l'Energie Atomique et aux Energies Alternatives 75015 Paris (FR)**

(72) Inventeurs:
• DUBOIS, Sébastien
  38054 Grenoble Cedex 09 (FR)
• ENJALBERT, Nicolas
  38054 Grenoble Cedex 09 (FR)
• GARANDET, Jean-Paul
  38054 Grenoble Cedex 09 (FR)

(74) Mandataire: **Nony
11 rue Saint-Georges
75009 Paris (FR)**

(54) **PROCÉDÉ D'EXTRACTION D'IMPURETÉS MÉTALLIQUES D'UNE PLAQUETTE DE SILICIUM CRISTALLIN**

(57) Procédé d'extraction d'impuretés métalliques d'une plaquette de silicium cristallin (10) comportant au moins une étape d'application, pendant une durée supérieure à 1 s, de préférence comprise entre 1 s et 30 min, une différence de potentiel électrique entre une première électrode et une deuxième électrode disposées du côté d'une même face (30) de la plaquette (10) pour faire migrer les impuretés métalliques vers une des première ou deuxième électrodes, la différence de potentiel électrique étant, en valeur absolue, comprise entre 1V et 10kV.

Fig. 1

EP 3 498 892 A1

# Description

La présente invention a pour objet un procédé d'extraction d'impuretés métalliques d'une plaquette de silicium cristallin. Elle a également trait à une cellule photovoltaïque ayant été traitée à l'aide dudit procédé.

Les plaquettes de silicium cristallin contiennent des impuretés métalliques telles que des atomes de cuivre, de nickel, de cobalt, de fer et/ou de chrome. Les concentrations de ces éléments sont généralement comprises entre $10^8$ cm$^{-3}$ et $10^{15}$ cm$^{-3}$.

Les plaquettes de silicium cristallin sont en particulier utilisées dans la fabrication de cellules photovoltaïques. Le rendement de conversion de ces dernières est limité par la présence des impuretés métalliques qu'elles contiennent. Ces dernières altèrent la durée de vie des porteurs de charges. Les impuretés métalliques peuvent également entraîner des effets de dégradation sous éclairement des performances des cellules qui les contiennent.

Pour s'affranchir de ces limitations, différents procédés pour extraire les impuretés métalliques d'une plaquette de silicium cristallin sont connus.

La plupart des procédés de fabrication des cellules photovoltaïques développent des effets getter externes et de passivation par l'hydrogène des impuretés métalliques initialement présentes dans le substrat. Les effets getter externes consistent à extraire des impuretés métalliques des régions actives de la cellule et à les confiner dans des régions où elles perdent leur nocivité. La technique privilégiée de mise en oeuvre des effets getter externes est l'étape de dopage superficiel de la plaquette, permettant de former la jonction pn de la cellule, notamment via la diffusion thermique du phosphore lorsque le substrat est de type p. Les effets de passivation par l'hydrogène sont généralement liés à l'utilisation de couches de nitrure de silicium hydrogéné, déposées sur les surfaces, desquelles migrent les atomes d'hydrogène pour électriquement passiver les impuretés restantes.

Ces traitements sont effectivement efficaces pour neutraliser une partie importante des impuretés métalliques initialement présentes dans le substrat. Cependant, à l'issue de ces traitements, les teneurs résiduelles en impuretés métalliques peuvent être encore suffisamment élevées pour limiter le rendement et provoquer des effets de dégradation sous éclairement des performances des cellules qui les contiennent.

Les demandes JP2007095774 et WO 2013/045767 présentent des procédés d'extraction des impuretés métalliques basés sur la génération de charges électriques à la surface d'une plaquette de silicium, afin d'établir un champ électrique dans le substrat, permettant aux atomes métalliques, comme le cuivre, de migrer sur l'une des surfaces. Dans ces demandes, le cuivre piégé à la surface de la plaquette est potentiellement instable. Il peut donc lors d'étapes successives ou au cours du fonctionnement du dispositif, migrer à nouveau dans la plaquette de silicium.

La demande JP2007095774 réduit ce risque en proposant de graver, par voie chimique, la surface de la plaquette sur laquelle se sont accumulés les éléments métalliques. Cependant, cela entraîne des étapes technologiques supplémentaires qui ne sont pas forcément compatibles avec le procédé de fabrication de la cellule photovoltaïque.

La demande internationale WO 2013/045767 propose d'établir le champ électrique en déposant ou formant des couches diélectriques à la surface des plaquettes, et de déposer une charge Corona. Cependant, le dépôt de charges Corona est difficile à contrôler et est mal adapté aux surfaces de plaquettes de silicium. De plus, la présence de charges Corona est parfois préjudiciable à l'utilisation ultérieure de la plaquette.

WO 2013/045767 propose également de déposer directement une couche diélectrique contenant des charges fixes. Cependant cela restreint le choix des couches diélectriques pouvant être déposées, ce qui offre peu de flexibilité en matière d'architecture des cellules.

L'article W.P. Lee et al, Journal of ELECTRONIC MATERIALS, Vol. 34, No. 7, 2005 ainsi que les brevets US 5,770,000 et US 6,534,748 proposent d'appliquer une différence de potentiel électrique entre deux électrodes disposées de chaque côté d'un échantillon semi-conducteur. Sous l'effet du champ électrique alors présent, les impuretés métalliques sont extraites du matériau semi-conducteur. Dans ces documents, les électrodes sont placées en vis-à-vis des deux côtés de l'échantillon et une des électrodes est espacée de l'échantillon par une couche de vide ou de gaz. Ainsi, la mise en oeuvre des traitements décrits dans ces documents nécessite l'utilisation d'une enceinte spécifique, dans laquelle il est possible de faire le vide ou d'injecter des gaz. De plus, le contrôle de la valeur du champ électrique créé dans le volume du dispositif est complexe.

Il est également connu des demandes WO 2007/107351, DE 10 2009 059 300 et FR 2 949 607 un traitement de cellules photovoltaïques comportant une jonction pn permettant de neutraliser de façon permanente un complexe associant le bore et l'oxygène. Ce traitement utilise les actions combinées de la température supérieure ou égale à 50°C et de l'injection de charges minoritaires dans la cellule. Les charges minoritaires sont injectées par l'application d'une différence de potentiel électrique entre deux électrodes disposées de part et d'autre de la cellule et donc de la jonction pn.

Il est également connu de la demande FR 2 949 607 un traitement d'une cellule photovoltaïque comportant une jonction pn utilisant les actions combinées de la température comprise entre 300°C et 500°C et de la polarisation électrique en direct d'une structure de collecte des charges minoritaires. La polarisation électrique permet d'injecter des charges libres dans le volume de la cellule. Ce traitement permet de limiter les effets de dégradation sous éclairement du rendement liés à la formation des complexes associant le bore et l'oxygène.

Au regard des limitations des procédés déjà disponibles, il demeure un besoin de disposer d'un procédé d'extraction des impuretés métalliques d'une plaquette de silicium cristallin qui soit à la fois efficace et facile à mettre en oeuvre.

L'invention vise précisément à répondre à ce besoin, selon un premier de ses aspects, et elle y parvient à l'aide d'un procédé d'extraction d'impuretés métalliques d'une plaquette de silicium cristallin comportant une étape d'application, pendant une durée supérieure ou égale à 1s, de préférence entre 1 s et 30 min, une différence de potentiel électrique entre une première électrode et une deuxième électrode disposées du côté d'une même face de la plaquette pour faire migrer les impuretés métalliques vers l'une des première ou deuxième électrodes, la différence de potentiel électrique étant, en valeur absolue, comprise entre 1V et 10kV, mieux comprise entre 3V et 5kV.

L'application de la différence de potentiel électrique entre les deux électrodes permet de créer un champ électrique dans la plaquette qui induit, sur les impuretés métalliques chargées, une force F vers l'une des électrodes. Une telle force F favorise la migration des impuretés métalliques vers ladite électrode, ce qui permet de piéger ces dernières en surface de la plaquette en regard de l'électrode, ou dans l'électrode. La migration des impuretés se fait à condition que la force appliquée l'emporte sur la diffusion brownienne, c'est-à-dire à condition que la force soit telle que :

$$FL_{Drift}/kT \gg 1$$

$L_{Drift}$ correspondant à la distance entre l'impureté et la surface vers laquelle elle migre, k la constante de Boltzmann et T la température en Kelvin.

La disposition des électrodes sur la même face permet d'avoir un champ électrique sensiblement uniforme dans la plaquette. Par rapport à la configuration où les électrodes sont en vis-à-vis sur deux faces distinctes de la plaquette, la disposition des électrodes selon l'invention permet d'appliquer le champ électrique de façon plus uniforme.

De préférence, les impuretés métalliques extraites sont parmi les métaux diffuseurs dits rapides, notamment le cuivre, le fer, le cobalt, le nickel, le manganèse et le chrome.

De préférence, la plaquette présente une épaisseur comprise entre 5 $\mu$m et 2 mm, mieux entre 40 $\mu$m et 200 $\mu$m.

De préférence, le procédé comporte une étape préalable de dopage des surfaces de la plaquette, notamment par diffusion thermique de phosphore, de bore, d'arsenic ou de gallium, préférentiellement de phosphore ou de bore.

Le dopage des surfaces de la plaquette permet de créer la jonction pn et d'extraire une partie des impuretés métalliques par effet getter externe.

De préférence, le procédé comporte une étape de dépôt ou de formation des première et deuxième électrode.

De préférence, le procédé comporte une étape de recuit de la plaquette, dit recuit rapide, en particulier à une température comprise entre 600°C et 1300°C, de préférence d'environ 800°C, pendant une durée comprise entre 1s et 10 min, de préférence d'une dizaine de secondes environ, avant un refroidissement à une vitesse de refroidissement supérieure ou égale en valeur absolue à 10 K.s$^{-1}$, de préférence comprise entre 40 K.s$^{-1}$ et 60 K.s$^{-1}$, de préférence entre 45 K.s$^{-1}$ et 55 K.s$^{-1}$, mieux sensiblement égale à 50 K.s$^{-1}$. De préférence, cette étape à lieu entre l'étape de dépôt ou de formation des première et deuxième électrodes et l'étape d'application de la différence de potentiel électrique. En variante, l'étape de recuit a lieu simultanément à l'étape d'application de la différence de potentiel électrique.

Le recuit de la plaquette permet de favoriser la dissolution des précipités métalliques et de laisser les impuretés métalliques de la plaquette en solution solide.

De préférence, le procédé comporte une étape de dépôt d'une troisième électrode soit sur la face opposée à celle du côté des première et deuxième électrodes de la plaquette, soit sur la même face que les première et deuxième électrodes.

La troisième électrode est déposée en prévision de l'utilisation ultérieure de la plaquette, notamment dans une cellule photovoltaïque.

De préférence, le procédé est mis en oeuvre à une température comprise entre 10°C et 850°C, mieux entre 15°C et 300°C, encore mieux entre 80°C et 270°C.

De préférence, le procédé est mis en oeuvre à atmosphère ambiante.

La première et la deuxième électrode peuvent être déposées ou formées en contact direct avec la plaquette ou une couche ou une pluralité de couches en contact direct avec la plaquette.

De préférence, la plaquette de silicium présente moins de 10$^{15}$ at.cm$^{-3}$ de bore et moins de $4 \times 10^{17}$ at. cm$^{-3}$ d'oxygène.

La différence de potentiel électrique entre la première électrode et la deuxième électrode peut être positive ou négative. Une différence de potentiel électrique entre la première et la deuxième électrode positive permet de faire migrer les impuretés métalliques de charge généralement positive vers l'une des électrodes, une différence de potentiel électrique négative permet de faire migrer les impuretés métalliques de charge généralement positive vers l'autre des électrodes.

De préférence, la plaquette de silicium ne comporte pas de jonction pn entre les première et deuxième électrodes. Ceci permet de limiter les dégradations de la plaquette et donc du futur dispositif photovoltaïque.

De préférence, les première et deuxième électrodes sont déposées sur des zones de la plaquette de même dopage.

De préférence, les première et deuxième électrodes sont espacées d'une distance supérieure à l'épaisseur de la plaquette. Ceci permet que les lignes de champ électrique entre les deux pistes soient distribuées sur toute l'épaisseur de la plaquette, ce qui permet un traitement sensiblement uniforme de la plaquette.

De préférence, les première et deuxième électrodes sont espacées d'une distance comprise entre 10 $\mu$m et 20 mm, mieux entre 100 $\mu$m et 5 mm.

De préférence, les distances minimales entre la première et la deuxième électrode sont constantes sur toute la surface de la plaquette.

De préférence, la première électrode comporte au moins deux pistes et la deuxième électrode comporte au moins une piste intercalée entre les deux pistes de la première électrode.

De préférence, la piste de la deuxième électrode est à égale distance des pistes de la première électrode. Ceci permet d'homogénéiser le champ électrique appliqué dans la plaquette.

De préférence, la première électrode et la deuxième électrode présentent chacune des pluralités de pistes, les pistes de la première électrode étant intercalées entre les pistes de la deuxième électrode. De préférence, les pistes des première et deuxième électrodes sont interdigitées. Une telle configuration des électrodes permet de traiter une grande surface de la plaquette efficacement et uniformément. Des électrodes avec de tels motifs, notamment en forme de peigne, facilitent également par la suite les procédés d'interconnexion des cellules en modules.

De préférence, les pistes de première électrode sont parallèles entre elles et séparées d'une distance comprise entre 0,3 mm et 3 mm, mieux entre 0,5 mm et 2 mm.

De préférence, les pistes de deuxième électrode sont parallèles entre elles et séparées d'une distance comprise entre 0,3 mm et 3 mm, mieux entre 0,5 mm et 2 mm.

De préférence, les pistes de première électrode sont sensiblement parallèles à la ou aux pistes de deuxième électrode, la ou les pistes de deuxième électrode s'étendant de préférence à égale distance des pistes de première électrode adjacentes.

La largeur des pistes de première et deuxième électrodes peut être comprise entre 10 $\mu$m et 1 mm, mieux entre 50 $\mu$m et 250 $\mu$m.

De préférence, les pistes de première et deuxième électrodes sont rectilignes.

De préférence, le procédé comporte une étape de recouvrement partielle de la face de la plaquette par au moins une couche diélectrique, puis une étape de dépôt de la première et/ou la deuxième électrode pour qu'elles s'étendent sur une ou plusieurs zones d'ouvertures de la couche diélectrique. Par « zones d'ouvertures », on comprend des zones ou la couche diélectriques est absente. Une telle couche diélectrique permet d'isoler électriquement la plaquette de la deuxième électrode dans les zones où elle est présente. De préférence, la couche diélectrique présente une pluralité de zones d'ouvertures formant un premier motif et un deuxième motif interdigité au premier motif, le premier motif recevant les pistes de première électrode et le deuxième motif recevant les pistes de deuxième électrode, les pistes de première électrode étant reliées entre elles par un premier contact de liaison (autrement appelé « bus bar ») s'étendant entre les pistes de première électrode sur la couche diélectrique et les pistes de deuxième électrode étant reliées entre elles par un deuxième contact de liaison s'étendant entre les pistes de deuxième électrode sur la couche diélectrique. De préférence, le premier contact de liaison s'étend d'un premier côté des première et deuxième électrodes et le deuxième contact de liaison s'étend d'un deuxième côté, opposé au premier côté, des première et deuxième électrodes. En variante, les premier et deuxième contacts de liaisons s'étendent du même côté des première et deuxième électrodes.

De préférence, les première et deuxième électrodes sont imprimées par sérigraphie.

En particulier, le procédé comporte en outre une étape de dépôt au moins partiel de la première électrode et/ou de la deuxième électrode en contact de la plaquette.

En variante, le procédé comporte une étape de recouvrement partielle de la plaquette d'une couche isolante d'épaisseur comprise entre 2 nm et 500 nm, mieux entre 10 nm et 300 nm et à déposer la première électrode et/ou la deuxième électrode sur la couche isolante.

La ou les couches isolantes peuvent être constituées d'un ou de plusieurs matériaux diélectriques, notamment choisis parmi $SiO_x$, $SiN_x$, $AlO_x$, $HfO_2$, SiON.

La présence d'une couche isolante entre l'électrode et la surface de la plaquette permet d'éviter le passage d'un courant électrique permanent dans la plaquette lors de l'application de la différence de potentiel électrique et d'éviter ainsi que la plaquette chauffe, ce qui pourrait entraîner des dégradations irréversibles de cette dernière et du dispositif photovoltaïque associé.

De préférence, dans le cas où au moins une couche isolante est présente entre une des électrodes et la plaquette, la différence de potentiel électrique appliquée entre les première et deuxième électrodes est comprise, en valeur absolue, entre 10 V et 10 kV.

En variante, les deux électrodes sont en contact direct avec la plaquette. Dans ce cas, la différence de potentiel électrique appliquée entre les première et deuxième électrodes est, de préférence, comprise, en valeur absolue, entre 1 V et 100 V.

En variante, dans le cas où au moins une couche isolante est présente entre une des électrodes et la plaquette, avant d'appliquer la différence de potentiel électrique, le procédé peut comporter après le dépôt des première et deuxième électrodes une étape de recuit à une température comprise entre 400°C et 700°C pendant une durée comprise entre 3 s et 30 min. Cette étape permet d'améliorer la conductivité des électrodes sans endommager la couche isolante.

Le procédé peut comporter une étape de dépôt des première et deuxième électrodes sur une couche isolante par sérigraphie et une étape de recuit dans un four à passage à lampes infra-rouge, à une température comprise entre 650°C et 850°C pendant une durée comprise entre 1 s et 3 min. Une telle étape de recuit est dit « de type firing ». Il permet aux première et deuxième électrodes de venir en contact direct avec la plaquette.

De préférence, le procédé peut comporter une ou les deux étapes suivantes après l'étape d'application de la différence de potentiel électrique :

- irradiation laser de la première et/ou deuxième électrodes, notamment pour permettre le contact entre lesdites électrodes et la plaquette lorsque la première et/ou la deuxième électrode sont déposées sur la couche isolante, et/ou
- une étape de recuit dit « de type firing » dans un four à passage à lampes infra-rouge, à une température comprise entre 650°C et 850°C pendant une durée comprise entre 1 s et 3 min, cela étant particulièrement avantageux lorsque la différence de potentiel électrique a été appliquée alors qu'au moins une couche isolante était présente entre une des électrodes et la plaquette.
- interconnexion des première et deuxième électrodes pour former une unique électrode combinée.

En variante, l'étape de recuit a lieu simultanément à l'étape d'application de la différence de potentiel électrique. De préférence, la face du côté des première et deuxième électrodes présente une succession de zones fortement dopées $p^+$ et $n^+$, les première et deuxième électrodes se superposant aux zones fortement dopées $p^+$ uniquement ou aux zones fortement dopées $n^+$ uniquement.

Le procédé peut comporter une étape de dépôt d'une troisième électrode du même côté que les première et deuxième électrodes, la troisième électrode étant disjointes des première et deuxième électrodes, la troisième électrode se superposant aux zones fortement dopées $n^+$ lorsque les première et deuxième électrodes se superposent aux zones fortement dopée $p^+$ et aux zones fortement dopées $p^+$ lorsque les première et deuxième électrodes se superposent aux zones fortement dopée $n^+$.

Une telle organisation des électrodes permet d'extraire les impuretés métalliques d'une plaquette destiné à être utilisée dans une cellule à contacts arrières tout en restant compatible avec le procédé de fabrication d'une telle cellule, et sa future mise en module.

De préférence, les première, deuxième et troisième électrodes présentent chacune une pluralité de pistes reliées entre elles par respectivement un premier, deuxième et troisième contact de liaison.

De préférence, les première, deuxième et troisième électrodes présentent une pluralité de pistes, les première et deuxième électrodes présentant des pistes qui s'intercalent alternativement entre les pistes de la troisième électrode. Ainsi, dans la direction X, la succession de pistes suivante se répète : piste de première électrode/piste de troisième électrode/piste de deuxième électrode/piste de troisième électrode. Il y a donc une alternance de pistes de première électrode/troisième électrode/deuxième électrode/troisième électrode dans au moins une direction de la plaquette sur cette dernière, notamment une direction perpendiculaire à une direction d'extension des pistes.

De préférence, le procédé comporte après l'étape d'extraction des impuretés une étape de jonction électrique des première et deuxième électrodes pour former une électrode combinée, l'électrode combinée et la troisième électrode étant interdigitées.

L'électrode combinée et la troisième électrode permettront d'extraire le photo-courant généré par la cellule à contacts arrière interdigités, et serviront ultérieurement à l'interconnexion des différentes cellules pour la fabrication du module complet.

Les pistes de première, deuxième et troisième électrodes sont, de préférence, parallèles entre elles.

La présente invention vise en outre un dispositif d'extraction d'impuretés métalliques d'une ou plusieurs plaquettes de silicium cristallin, pour mettre en oeuvre le procédé précédemment décrit, comportant au moins :

- un premier conducteur,
- un deuxième conducteur disjoint du premier conducteur, et
- un générateur de tension entre les premier et deuxième conducteurs pour générer entre les deux conducteurs une différence de potentiel électrique comprise entre 1V et 10kV, le premier conducteur étant configuré pour se superposer à la première électrode et le deuxième conducteur étant configuré pour se superposer à la deuxième électrode.

De préférence, le premier conducteur présente un bras conducteur et le deuxième conducteur présente deux bras conducteurs, le bras conducteur du premier conducteur étant intercalé entre les bras conducteurs du deuxième conducteur. Il est alors possible d'extraire les impuretés métalliques d'une pluralité de plaquettes simultanément en disposant les plaquettes portant les première et deuxième électrodes sur un bras du premier conducteur et un bras du deuxième conducteur de sorte que l'une des première et deuxième électrodes est en contact avec le bras conducteur du premier conducteur et l'autre des première et deuxième électrodes est dénuée de contact avec le premier conducteur et est en contact avec un des bras conducteurs du deuxième conducteur et la ou les plaquettes portant les première et deuxième électrodes.

De préférence, le dispositif d'extraction comporte également un four dans lequel sont placés les premier et deuxième conducteurs.

## Description détaillée

L'invention pourra être mieux comprise à la lecture de la description détaillée qui va suivre, d'exemples non limitatifs de mise en oeuvre de celle-ci, et à l'examen du dessin annexé, sur lequel :

- la figure 1 est une représentation schématique et partielle, en coupe, d'un exemple de disposition des électrodes sur la plaquette de silicium cristallin,
- la figure 2 illustre une variante de la figure 1,
- la figure 3 représente partiellement, en vue du dessous, une variante de disposition des électrodes sur la plaquette de silicium cristallin,
- la figure 4 est une vue en coupe partielle selon IV-IV de la variante de la figure 3,
- la figure 5 est une vue en coupe partielle selon V-V de la variante de la figure 3,
- la figure 6 est un graphique représentant le temps de traitement pour l'extraction du cuivre d'une plaquette de silicium cristallin par rapport à la différence de potentiel électrique appliquée, et ce pour différentes températures de traitement, les électrodes étant disposées sur la plaquette de silicium selon la variante des figures 3 à 5,
- la figure 7 illustre une variante de la figure 4,
- la figure 8 illustre une variante de la figure 5,
- la figure 9 illustre une variante de la figure 3,
- la figure 10 est une vue en coupe partielle selon X-X de la variante de la figure 9,
- la figure 11 est une vue en coupe partielle selon XI-XI de la variante de la figure 9,
- la figure 12 représente un exemple de dispositif permettant de mettre en oeuvre le procédé selon l'invention,
- la figure 13 est une vue en coupe selon XIII-XIII de la figure 12,
- la figure 14 est un graphique représentant le temps de traitement pour l'extraction du cuivre d'une plaquette de silicium cristallin par rapport à la différence de potentiel électrique appliquée, et ce pour différentes concentration de bore dans la plaquette de silicium cristallin, les électrodes étant disposées sur la plaquette de silicium selon la variante des figures 3 à 5, et
- la figure 15 est un graphique représentant le temps de traitement pour l'extraction du fer d'une plaquette de silicium cristallin par rapport à la différence de potentiel électrique appliquée, et ce pour différentes températures de traitement, les électrodes étant disposées sur la plaquette de silicium selon la variante des figures 3 à 5.

Différentes étapes d'un exemple de procédé d'extraction d'impuretés métalliques d'une plaquette de silicium cristallin, selon l'invention, sont décrites en détails dans ce qui suit.

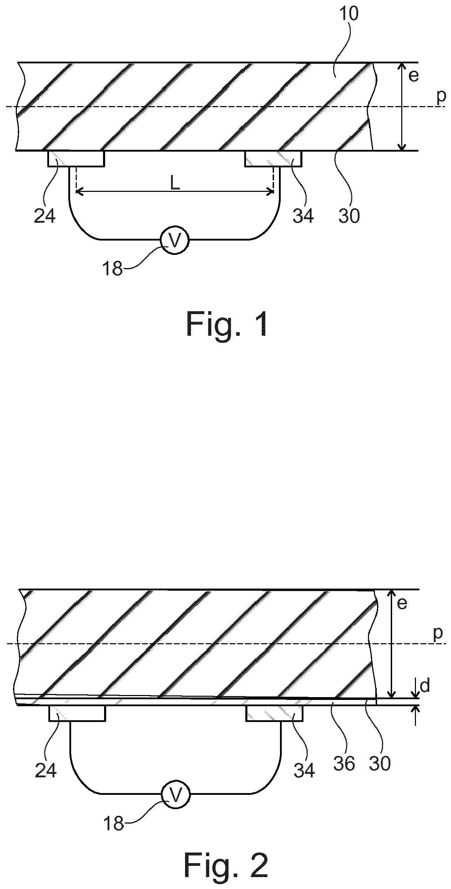

On a représenté en figure 1 un exemple de disposition des électrodes sur une plaquette de silicium cristallin 10 permettant de mettre en oeuvre un procédé d'extraction des impuretés métalliques selon l'invention.

La plaquette de silicium 10 s'étend dans un plan d'extension P.

Elle présente une face 30 sur laquelle sont disposées au moins une première électrode 22 et une deuxième électrode 32, disjointe de la première électrode. Dans ce mode particulier de réalisation, les deux électrodes 22 et 32 présentent chacune une piste 24 et 34 respectivement en contact direct avec la plaquette 10.

De préférence, les première et deuxième électrodes 22 et 32 sont déposées par sérigraphie.

La plupart des impuretés métalliques présentes dans la plaquette 10 en position interstitielle ou substitutionnelle sont chargées électriquement, généralement positivement.

Les pistes 24 et 34 sont espacées d'une distance L, mesurée entre les centres des surfaces des pistes 24 et 34, supérieure à l'épaisseur de la plaquette 10. La distance L peut être comprise entre 10 μm et 20 mm, préférentiellement entre 100 μm et 5 mm.

L'épaisseur e de la plaquette 10 est comprise entre 5 μm et 2 mm, de préférence entre 40 μm et 200 μm.

L'invention consiste à appliquer une différence de potentiel électrique V entre les deux électrodes 22 et 32. La différence de potentiel électrique V est appliquée à l'aide d'un générateur de tension 18 ou toute autre moyen. La différence de potentiel électrique V appliquée entre les deux électrodes 22 et 32 est comprise, en valeur absolue, entre 1 V et 100 V, par exemple sensiblement égale à 15 V, pendant une durée comprise entre 1 s et 10 minutes, par exemple sensiblement égale à 5 s.

Le champ électrique créé par cette différence de potentiel électrique $V$, induit une force $F$ sur les impuretés chargées, qui va favoriser leur migration vers l'une des électrodes 22 ou 32. Les impuretés métalliques vont alors être piégées au niveau de la face 30 à proximité d'une des électrodes 22 ou 32 voire dans l'électrode métallique 22 ou 32.

La force $F$ locale est définie par :

$$F = CV/L \quad (1)$$

$C$ étant la charge portée par l'impureté considérée.

Sous cette force $F$, l'impureté métallique chargée va migrer à la vitesse $V_{Drift}$ définie par :

$$V_{Drift} = DF/kT \quad (2)$$

$D$ étant le coefficient de diffusion de l'impureté considérée, $k$ la constante de Boltzmann et $T$ la température en Kelvin.

$V_{Drift}$ étant connue, le temps nécessaire $t_{Drift}$ à l'impureté métallique pour migrer sous cette différence de potentiel électrique sur la distance $L_{drift}$ vers l'électrode 22 ou 32 peut alors être calculé :

$$t_{Drift}=L_{drift}/V_{Drift} \quad (3)$$

A noter que, dans l'invention, la diffusion sous champ électrique doit dominer la diffusion brownienne à l'échelle de longueur $L_{Drift}$. Pour cela, $V_{Drift}$ doit être plus grand que $V_B$, $V_B$ étant définie par :

$$V_B=D/L_{Drift} \quad (4)$$

Cela suppose la condition suivante :

$$FL_{Drift}/kT>>1 \quad (5)$$

Cette condition est vérifiée par l'invention et dans les exemples décrits ci-dessous.

L'invention concerne toutes les impuretés métalliques électriquement chargées, en particulier les diffuseurs dits rapides dans le silicium, par exemple le cuivre, le fer, le cobalt, le nickel, le manganèse et le chrome. L'invention peut être mise en oeuvre quel que soit la concentration d'impuretés dans la plaquette. Toutefois, elle est particulièrement efficace quand la concentration en impuretés métalliques est supérieure à sa limite de solubilité. L'invention n'est cependant pas limitée à une telle condition.

Pour faciliter la mise en oeuvre de l'invention, en particulier pour favoriser son utilisation à l'échelle industrielle, il est possible de chauffer l'échantillon. Ceci permet d'augmenter la valeur de $D$ et donc de la vitesse de migration des impuretés. La température peut être comprise entre 10°C et 850°C, de façon préférentielle entre 15°C et 250°C.

L'invention peut être mise en oeuvre après une étape de recuit. Le recuit peut se faire selon un profil de température en fonction du temps tel que décrit dans l'article S. Dubois et al, SolMat, 2016. Un mode préférentiel de mise en oeuvre de l'invention est d'appliquer la différence de potentiel électrique juste après le recuit de la plaquette, dans le four infra-rouge de recuit des contacts. Un tel recuit permet de favoriser la dissolution des précipités métalliques et d'immobiliser les impuretés métalliques dans la plaquette. En variante, il peut être intéressant d'appliquer la différence de potentiel électrique pendant le recuit des contacts, dans le four à passage à lampes infra-rouge.

L'invention peut être mise en oeuvre selon un second mode de réalisation illustré en figure 2. Le mode de réalisation de la figure 2 diffère de celui de la figure 1 en ce que les pistes 24 et 34 de première et deuxième électrode 22 et 32 sont séparées au moins partiellement de la face 30 de la plaquette 10 par une couche isolante 36. Cette couche isolante 36 permet d'éviter le passage d'un courant électrique permanent dans la plaquette 10 lors de l'application de la différence de potentiel électrique V, et par conséquent de limiter l'échauffement de la plaquette, ce qui pourrait causer une dégradation irréversible de cette dernière.

La couche isolante 36 peut présenter une épaisseur $d$ comprise entre 2 nm et 500 nm, de préférence entre 10 nm et 300 nm. Elle peut comporter un unique matériau diélectrique ou plusieurs matériaux diélectriques tels que SiOx, SiNx, AlOx, HfO2, SiON. Elle peut être constituée de couches anti-reflet et/ou de passivation électrique déposées pour la fabrication des cellules photovoltaïques. Dans ce cas, la différence de potentiel électrique V entre les deux électrodes 22 et 32 est préférentiellement comprise, en valeur absolue, entre 10 V et 10kV pendant une durée comprise entre 1 s et 30 min.

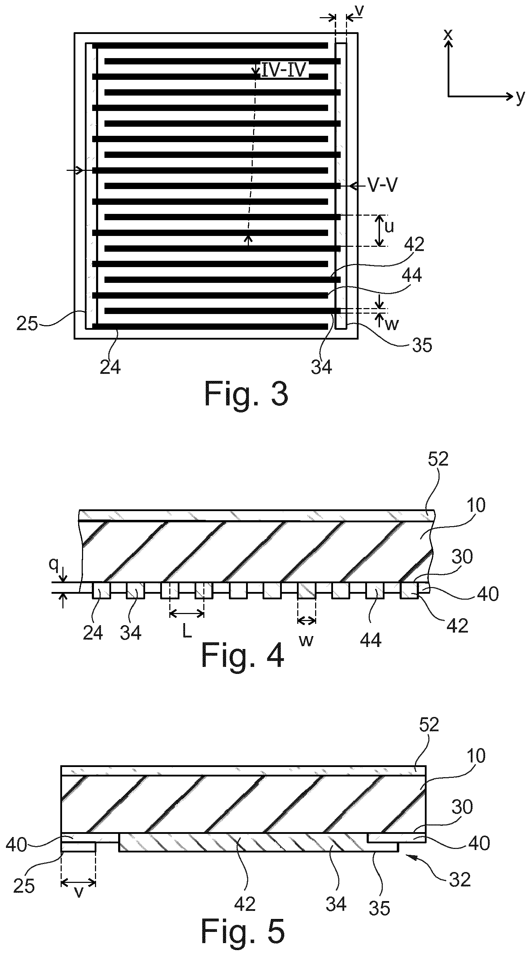

Les figures 3 à 11 illustrent des configurations possibles pour les première et deuxième électrodes. Ces configurations sont décrites en détail en relation avec les exemples 1 à 3. L'invention n'est cependant pas limitée à ces configurations.

## Exemple 1

Un premier exemple de procédé est décrit ci-dessous en relation avec les figures 3 à 6.

Dans cet exemple, une plaquette de silicium cristallin 10 de dimensions 156 mm par 156 mm de type p dopée au bore avec une concentration de bore sensiblement égale à $8,0 \times 10^{15}$ cm$^{-3}$ et contenant du cuivre à une teneur voisine de $10^{14}$ cm$^{-3}$ est utilisée. Cette plaquette a subi une étape de texturation et de nettoyage. Elle présente une épaisseur e sensiblement égale à 170 μm.

Le procédé suivant les étapes suivantes lui est appliqué :

1) diffusion thermique du phosphore,
2) décapage de la zone diffusée P en face arrière 30 et polissage de la face arrière 30,
3) dépôt en face avant 20 d'une couche anti-reflet 50 SiNx : H,
4) dépôt en face arrière 30 d'une couche diélectrique 40 de AlOx/SiNx : H,
5) ablation locale au laser de la couche diélectrique 40 pour former des zones découvertes 42 et 44,
6) impression d'une troisième électrode métallique 52 en face avant,
7) impression de la première électrode métallique 22 en face arrière 30 sur au moins une partie des zones découvertes 44,
8) impression de la deuxième électrode métallique 32 en face arrière 30 sur au moins une partie des zones découvertes 42,
9) cuisson autour de 780 °C pour l'activation des électrodes et la prise de contact entre les électrodes 22, 32 et 52 et la plaquette 10,

10) chauffage et application d'une différence de potentiel électrique V entre les deux électrodes 22 et 32 pendant un temps t, et

11) interconnexion des première et deuxième électrodes 22 et 32.

La concentration en cuivre après l'étape de diffusion phosphore est de l'ordre de $10^{11}$ cm$^{-3}$.

La face arrière 30 est recouverte à l'étape 4) d'une couche diélectrique 40 visible sur les figures 4 et 5. La couche diélectrique 40 est retirée par ablation au laser à l'étape 5) dans des zones découvertes 42 et 44. Comme cela est illustré sur les figures 3 à 5, les zones découvertes 42 forment un premier motif constitué de lignes continues parallèles identiques s'étendant chacune selon une direction Y et alignées entre elles selon une direction X perpendiculaire à la direction Y et les zones découvertes 44 forment un deuxième motif constitué de lignes continues parallèles identiques s'étendant chacune selon la direction Y et alignées entre elles selon la direction X. Les zones découvertes 44 sont intercalées entre les zones découvertes 42, préférentiellement à égale distance des zones 42 adjacentes et décalées dans la direction Y des zones découvertes 42. De préférence, les zones découvertes 42 et 44 sont identiques.

La largeur w des zones découvertes 42 et 44 est comprise entre 10 $\mu$m et 250 $\mu$m, la distance u entre deux zones 42, respectivement 44, parallèles est comprise entre 500 $\mu$m et 2 mm, par exemple sensiblement égale à 1,4 mm dans le cas illustré à la figure 3. La couche diélectrique 40 présente une épaisseur q comprise entre 2 nm et 500 nm.

A l'étape 6), une troisième électrode 50 est imprimée en face avant 20. Une telle électrode 50 est imprimée en prévision de l'utilisation ultérieure de la plaquette 10, dans une cellule photovoltaïque notamment.

A l'étape 7), la première électrode 22 est imprimée en face arrière. Elle présente une pluralité de pistes 24 s'étendant dans les zones 44 et reliées entre elles à une de leur extrémité par un contact de jonction 25. Le contact de jonction 25 se superpose entre les pistes 24 à la couche diélectrique 40.

A l'étape 8), la deuxième électrode 32 est imprimée en face arrière. Elle présente une pluralité de pistes 34 s'étendant dans les zones 42 et reliées entre elles, à leur extrémité opposée au contact de jonction 25, par un contact de jonction 35. Comme cela est illustré sur la figure 5, le contact de jonction 35 se superpose entre les pistes 34 à la couche diélectrique 40.

Les électrodes 22 et 32 sont interdigitées.

De préférence, la largeur v des contacts de jonction 25 et 35 est comprise entre 0,4 mm et 3 mm.

Un tel exemple de procédé est simple à mettre en oeuvre et permet d'avoir une différence de potentiel électrique V qui s'applique de façon relativement uniforme sur la plaquette 10, ce qui favorise l'extraction des impuretés métalliques de l'ensemble du volume de la plaquette.

Dans l'exemple illustré sur la figure 3, la distance k entre deux pistes 24 est sensiblement égale à 2 mm et la distance L entre une piste 24 et une piste 34 adjacente est sensiblement égale à 1 mm.

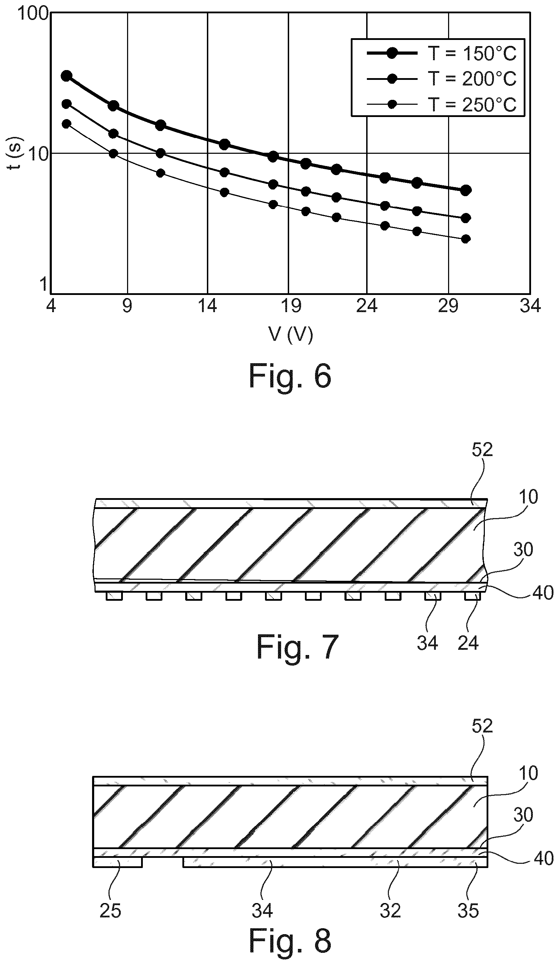

A partir des équations précédemment présentées, en considérant que $L=L_{Drift}$ et à partir du calcul du coefficient de diffusion du cuivre en prenant en compte les effets conjugués de la présence de bore et de la température, la variation du temps t nécessaire aux atomes de cuivre pour migrer sur une distance de 1 mm en fonction de la différence de potentiel électrique V appliquée entre les deux électrodes 22 et 32, a été déterminée, et ce pour différentes température T. La Figure 6 présente les résultats obtenus.

Ainsi, en fonction des cadences de production visées, des capacités de résistance de la cellule à l'augmentation de température et de la différence de potentiel électrique appliquée, les conditions de traitement les plus optimales peuvent être déterminées.

L'étape 10) pourrait consister à appliquer une différence de potentiel électrique de 15 V, à 250°C et ce pendant 5s.

**Exemple 2**

Un deuxième exemple de procédé est décrit ci-dessous en relation avec les figures 7 et 8.

Dans cet exemple, une plaquette de silicium cristallin 10 de dimensions 156 mm par 156 mm de type p dopée au bore avec une concentration de bore sensiblement égale à $8,0 \times 10^{15}$ cm$^{-3}$ et contenant du cuivre à une teneur voisine de $10^{14}$ cm$^{-3}$ est utilisée. Cette plaquette a subi une étape de texturation et de nettoyage. Elle présente une épaisseur e sensiblement égale à 170 $\mu$m.

Le procédé suivant les étapes suivantes lui est appliqué :

1) diffusion thermique de phosphore,

2) décapage de la zone diffusée en face arrière 30 et polissage de la face arrière 30,

3) dépôt en face avant 20 d'une couche anti-reflet 50 SiNx:H,

4) dépôt en face arrière 30 d'une couche diélectrique 40 de AlOx/SiNx : H,

5) impression d'une troisième électrode métallique 52 en face avant,

6) cuisson autour de 780 °C pour l'activation de l'électrode 52 et la prise de contact entre l'électrode 52 et la plaquette 10,

7) impression de la première et la deuxième électrode métallique 22 et 32 en face arrière 30

8) cuisson à une température comprise entre 400°C et 700°C pour améliorer la conductivité des électrodes,

9) chauffage et application d'une différence de potentiel électrique V entre les deux électrodes 22 et 32 pendant un temps t, et

10) irradiation laser des première et deuxième électrodes 22 et 32 pour la prise de contact entre les électrode 22 et 32 et la plaquette 10,

11) interconnexion des première et deuxième électrodes 22 et 32.

Les électrodes 22 et 32 se présentent et sont agencées de la même manière que dans l'exemple 1.

Dans cet exemple, les électrodes 22 et 32 sont imprimées par sérigraphie au étapes 7) et 8) selon les motifs de l'exemple 1 sur la couche diélectrique 40.

Dans cette configuration, la différence de potentiel électrique appliquée à l'étape 7) est préférentiellement comprise, en valeur absolue, entre 10 V et 10 kV. L'étape 7) peut consister à appliquer une différence de potentiel électrique de 800 V, à 250°C et ce pendant 6 s.

L'étape 10) consiste à irradier les pistes 24 et 34 des électrodes pour supprimer la couche diélectrique 40 sous ces dernières et pour que les pistes 24 et 34 soient directement au contact de la plaquette 10. Les contacts de liaisons 25 et 35 ne sont pas irradiés. Les électrodes 22 et 32 sont alors telles qu'illustré en relation avec l'exemple 1.

**Exemple 3**

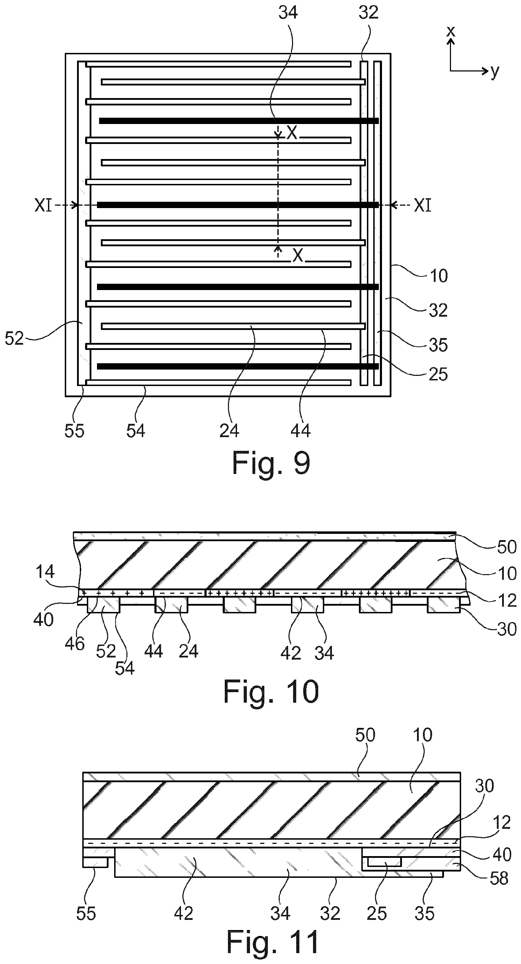

Un troisième exemple de procédé est décrit ci-dessous en relation avec les figures 9 à 11.

Dans cet exemple, la plaquette 10 est de type n dopée au phosphore avec une concentration de phosphore sensiblement égale à $10^{16}$ cm$^{-3}$ et contenant du cuivre à une teneur voisine de $10^{14}$ cm-3 est utilisée. Dans cet exemple est illustrée la configuration IBC, la face arrière 30 de la plaquette 10 comporte des zones 12 fortement dopées n$^+$ alternant avec des zones 14 fortement dopées p$^+$.

Le procédé suivant les étapes suivantes lui est appliqué :

1) dépôt en face avant 20 d'une couche anti-reflet 50 SiNx:H,

2) dépôt en face arrière 30 d'une couche diélectrique 40 de AlOx/SiNx : H,

3) ablation locale au laser de la couche diélectrique 40 pour former des zones découvertes 42 et 44 sur les zones 12 dopées n$^+$ et des zones découvertes 46 sur les zones 14 dopées p$^+$,

4) impression de la troisième électrode métallique 52 en face arrière 30 au moins en partie sur au moins une partie des zones découvertes 46,

5) impression de la première électrode métallique 22 en face arrière 30 au moins en partie sur au moins une partie des zones découvertes 44,

6) dépôt d'une couche isolante 58 sur le contact de liaison 25 de la première électrode 22, au moins sur les zones qui seront en l'étape 7) recouverte par la deuxième électrode métallique 32,

7) impression de la deuxième électrode métallique 32 en face arrière 30 au moins en partie sur au moins une partie des zones découvertes 42,

8) cuisson autour de 750°C pour l'activation des électrodes et la prise de contact entre les électrodes 52, 22 et 32 et la plaquette 10,

9) chauffage et application d'une différence de potentiel électrique V entre les deux électrodes 22 et 32 pendant un temps t, et

10) interconnexion des première et deuxième électrodes 22 et 32.

Dans cet exemple, la troisième électrode 52 est imprimé en face arrière 30 et forme des pistes 54 sur les zones découvertes 46 se superposant au zones 14 dopées p$^+$. Elle se présente de la même manière que la première électrode dans le cas des exemples 1 et 2 décrits ci-dessus.

Les première et deuxième électrodes 22 et 32 présentent des pistes 24 et 34 qui s'intercalent alternativement entre les pistes 54 de la troisième électrode 52. Ainsi, dans la direction X, la succession de pistes 24, 34 et 54 suivante se répète : piste 24/piste 54/piste34/piste 54. Les pistes 24, respectivement 34, sont reliées entre elles, à leur extrémité opposée au contact de liaison 55 de la troisième électrode 52, par le contact de liaison 25, respectivement 35. Le contact de liaison 35 est en arrière du contact de liaison 25 par rapport aux pistes 24, 34 et 54 de sorte que les pistes 34 se superposent partiellement au contact de liaison 25. Afin d'éviter le contact électrique entre le contact de liaison 25 et les pistes 34, le contact de liaison 25 et les pistes 34 sont séparées par une couche isolante 58 déposée à l'étape 6).

Au moins une partie des électrodes, 22, 32 et 52, notamment une partie des lignes de jonction 25, 35 et 55, sont à nues de sorte à pouvoir appliquer la différence de potentiel électrique entre les électrodes 22, 32 et 52.

A la fin du procédé, à l'étape 10), les première et deuxième électrodes 22 et 32 sont interconnectées. Ceci permet que ces dernières forment une unique électrode combinée qui est interdigitée en face arrière avec la troisième électrode. La structure obtenue correspond donc à la structure d'une cellule à contact arrière interdigitée.

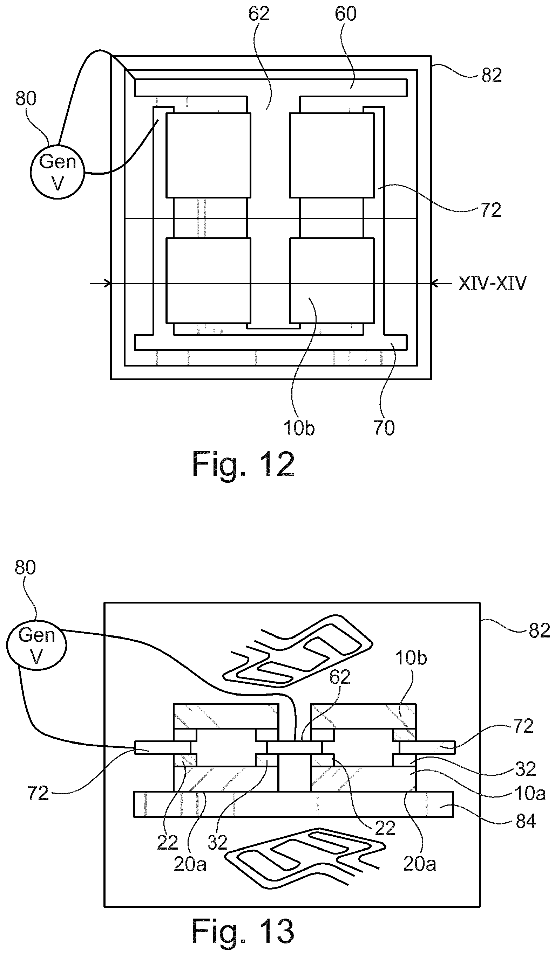

Les figures 12 et 13 illustrent un dispositif permettant d'extraire simultanément les impuretés métalliques de plusieurs plaquettes 10. Ce dispositif permet de traiter une pluralité de plaquettes 10, ici 8 plaquettes mais un plus grand nombre est possible. Le dispositif présente un premier conducteur 60 présentant un bras 62 et un deuxième conducteur 70 présentant deux bras 72, le premier conducteur 60 et le deuxième conducteur 70 étant disjoints. Le bras 62 est disposé entre les deux bras 72. Les deux conducteurs 60 et 70 sont reliés entre eux par un générateur de tension 80 permettant d'appliquer entre eux la différence de potentiel électrique décrite précédemment. Le dispositif comporte également un four 82 dans lequel les conducteurs 60 et 70 sont insérés.

Lors du traitement d'extraction des plaquettes 10, plusieurs plaquettes 10a revêtues des première et deuxième électrodes 22 et 32 sont disposées dans le four, les faces 20a ne portant pas les première et deuxième électrodes 22 et 32 étant posées sur un support isolant 84. Les plaquettes 10a sont disposées en deux rangées. Le bras 62 est disposé entre les deux rangées sur les plaquettes 10a de sorte à contacter une des deux électrodes 22 ou 32 de chaque plaquette 10a. Les bras 72 sont disposés sur les côtés extérieurs des rangées sur les plaquettes 10a de sorte à contacter l'autre des deux électrodes 22 ou 32 de chaque plaquette 10a. D'autres plaquettes 10b revêtues des première et deuxième électrodes 22 et 32 sont disposées au-dessus des plaquettes 10a de sorte qu'une de leurs électrodes 22 et 32 soit en contact avec le bras 62 et que l'autre des électrodes 22 et 32 soit en contact avec un des bras 72.

Ainsi, lorsque le générateur de tension 80 applique une différence de potentiel électrique entre les deux conducteurs 60 et 70, cela génère simultanément une différence de potentiel électrique entre les premières électrodes 22 et les deuxièmes électrodes 32 des plaquettes 10a et 10b. Ceci permet d'extraire en simultané les impuretés métalliques de toutes les plaquettes 10a et 10b.

### Exemple 4

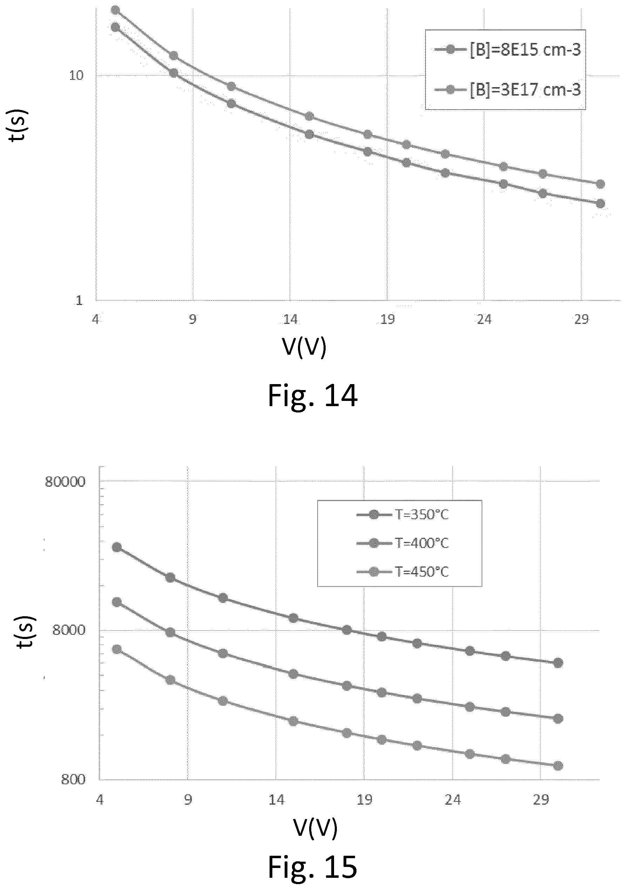

Un quatrième exemple de procédé est décrit ci-dessous en relation avec la figure 14.

Dans cet exemple, deux plaquettes de silicium cristallin 10 sensiblement identique à celle de l'exemple 1 à la teneur en bore près ont subies le procédé de l'exemple 1, la température de chauffage de l'étape 10 étant réalisée à 250°C. Les plaquettes de silicium cristallin présentent respectivement une teneur en bore de $3 \times 10^{17}$ cm$^{-3}$ et de $8 \times 10^{15}$ cm$^{-3}$.

La variation du temps t nécessaire aux atomes de cuivre pour migrer sur une distance de 1 mm en fonction de la différence de potentiel électrique V appliquée entre les deux électrodes 22 et 32, a été déterminée, et ce pour chacune des plaquettes de silicium cristallin. La figure 14 présente les résultats obtenus.

Comme visible sur la figure 14, pour une concentration en bore de $3 \times 10^{17}$ cm$^{-3}$, il est judicieux sous une différence de potentiel de 15 V, à 250°C, d'avoir un traitement d'une durée de 7 s et pour une concentration en bore de $3 \times 10^{15}$ cm$^{-3}$, il est judicieux sous une différence de potentiel de 15 V, à 250°C, d'avoir un traitement d'une durée de 5s environ. A noter que pour des teneurs en bore inférieures à $8,0 \times 10^{15}$ cm$^{-3}$ les temps de traitement sont identiques à ceux correspondants aux substrats dopés à $8,0 \times 10^{15}$ cm$^{-3}$. L'invention peut être mise en oeuvre pour des teneurs en bore dans la plaquette de silicium plus faible que celles des exemples 1 et 4, par exemple de l'ordre de $10^{13}$ à $10^{14}$ cm$^{-3}$.

Ainsi, la teneur en bore a une influence sur le coefficient de diffusion du cuivre pour des teneurs en bore supérieure ou égale à $10^{16}$ cm$^{-3}$ et l'invention n'est pas limitée à une teneur en bore minimum ou particulière dans la plaquette de silicium.

### Exemple 5

Un cinquième exemple de procédé est décrit ci-dessous en relation avec la figure 15.

On considère une plaquette de silicium cristallin 10 de dimensions 156 mm par 156 mm de type p dopée au bore avec une concentration de bore sensiblement égale à $8,0 \times 10^{15}$ cm$^{-3}$ et contenant du fer à une teneur voisine de $10^{14}$ cm$^{-3}$ est utilisée. Cette plaquette a subi une étape de texturation et de nettoyage. Elle présente une épaisseur e sensiblement égale à 170 $\mu$m.

Le procédé de l'exemple 1 lui est appliqué.

La concentration en fer après l'étape de diffusion phosphore est de l'ordre de $2 \times 10^{13}$ cm$^{-3}$.

A partir des équations précédemment présentées, en considérant que $L = L_{Drift}$ et à partir du calcul du coefficient de diffusion du fer en prenant en compte les effets conjugués de la présence de bore et de la température, la variation du temps t nécessaire aux atomes de fer pour migrer sur une distance de 1 mm en fonction de la différence de potentiel électrique V appliquée entre les deux électrodes 22 et 32, a été déterminée, et ce pour différentes température T. La figure 15 présente les résultats obtenus.

Ainsi, en fonction des cadences de production visées, des capacités de résistance de la cellule à l'augmentation de température et de la différence de potentiel électrique appliquée, les conditions de traitement les plus optimales peuvent être déterminées.

L'étape 10) pourrait consister à appliquer une différence de potentiel électrique de 20 V, à 450°C et ce pendant 1500 s.

Bien entendu, l'invention n'est pas limitée aux exemples qui viennent d'être décrits.

Par exemple, les électrodes peuvent présenter des formes différentes que celles décrites, par exemple une forme ondulée, curviligne ou concentrique.

Les électrodes peuvent être déposées autrement que par sérigraphie, notamment par évaporation sous vide, pulvérisation cathodique, électro-dépôt.

### Revendications

1. Procédé d'extraction d'impuretés métalliques d'une plaquette de silicium cristallin (10) comportant au moins une étape d'application, pendant une durée supérieure à 1 s, de préférence comprise entre 1 s et 30 min, une différence de potentiel électrique entre une première électrode (22) et une deuxième électrode (32) disposées du côté d'une même face (30) de la plaquette (10) pour faire migrer les impuretés métalliques vers une des première ou deuxième électrodes (22, 32), la différence de potentiel électrique étant, en valeur absolue, comprise entre 1V et 10kV.

**2.** Procédé selon la revendication 1, la distance *L* entre la première et la deuxième électrode (22, 32) étant supérieure à l'épaisseur de la plaquette (10).

**3.** Procédé selon la revendication 1 ou 2, la première électrode (22) comportant au moins deux pistes (24) et la deuxième électrode (32) comportant au moins une piste (34) intercalée entre les deux pistes (24) de la première électrode (22), de préférence la piste (34) de la deuxième électrode (32) étant à égale distance des pistes (24) de la première électrode (22).

**4.** Procédé selon l'une quelconque des revendications précédentes, la première électrode (22) et la deuxième électrode (32) présentant chacune des pluralités de pistes (24, 34), les pistes (24) de la première électrode (22) étant intercalées entre les pistes (34) de la deuxième électrode (32), notamment les pistes (24, 34) des première et deuxième électrodes (22, 32) étant interdigitées.

**5.** Procédé selon l'une quelconque des revendications précédentes, comportant une étape de recouvrement partielle de la face (30) de la plaquette (10) par au moins une couche diélectrique (40), puis une étape de dépôt de la première et/ou deuxième électrode (22, 32) pour qu'elle(s) s'étende(nt) sur une ou plusieurs zones d'ouvertures (42) de la couche diélectrique (40) pour définir dans lesdites zones la ou les pistes (24, 34) de première et/ou deuxième électrode (22, 32), de préférence la couche diélectrique (40) présentant une pluralité de zones d'ouvertures (42) de couche diélectrique (40) formant un premier motif et un deuxième motif interdigité au premier motif, le premier motif recevant les pistes (24) de première électrode (22) et le deuxième motif recevant les pistes (34) de deuxième électrode (32), les pistes (24) de première électrode (22) étant reliées entre elles par un premier contact de liaison (26) s'étendant entre les pistes (24) de première électrode (22) sur la couche diélectrique (40) et les pistes (34) de deuxième électrode (32) étant reliées entre elles par un deuxième contact de liaison (36) s'étendant entre les pistes (34) de deuxième électrode (32) sur la couche diélectrique (40).

**6.** Procédé selon l'une quelconque des revendications précédentes, comportant une étape de dépôt au moins partiel de la première et/ou la deuxième électrode (22, 32) directement en contact de la plaquette (10).

**7.** Procédé selon l'une quelconque des revendications précédentes, comportant une étape de recouvrement partielle de la plaquette (10) d'une couche isolante (36) d'épaisseur d comprise entre 2 nm et 500 nm, mieux entre 10 nm et 300 nm et de dépôt de la première et/ou la deuxième électrode (24, 34) sur la couche isolante (36), la différence de potentiel électrique appliquée entre les première et deuxième électrodes (22, 32) étant de préférence comprise, en valeur absolue, entre 10 V et 10 kV.

**8.** Procédé selon la revendication 6, la première et la deuxième électrode (22, 32) étant au moins partiellement en contact direct avec la plaquette (10) et la différence de potentiel électrique appliquée entre les première et deuxième électrodes (22, 32) étant comprise, en valeur absolue, entre 1 V et 100 V.

**9.** Procédé selon l'une quelconque des revendications précédentes, comportant avant l'application de la différence de potentiel électrique, avant ou après les étapes de dépôt des première et deuxième électrodes (22, 32) sur la plaquette (10), une étape de recuit rapide à une température comprise entre 600°C et 1300°C pendant une durée comprise entre 1 s et 10 min et avec une vitesse de refroidissement supérieure en valeur absolue à 10 K.s$^{-1}$.

**10.** Procédé selon l'une quelconque des revendications précédentes comprenant le dépôt d'une troisième électrode (52) soit sur la face opposée à celle du côté des première et deuxième électrodes (22, 32) de la plaquette (10), soit sur la même face (30) que les première et deuxième électrode (22, 32).

**11.** Procédé selon l'une quelconque des revendications précédentes, la face (30) du côté des première et deuxième électrodes (22, 32) présente une succession de zones (12, 14) fortement dopées p$^+$ et n$^+$, les première et deuxième électrodes (22, 32) se superposant aux zones (14) fortement dopées p$^+$ uniquement ou aux zones (12) fortement dopées n$^+$ uniquement.

**12.** Procédé selon l'une quelconque des revendications précédentes comprenant après l'étape d'extraction des impuretés une étape d'irradiation laser de la première et/ou deuxième électrodes (22, 32), notamment lorsque la première et/ou la deuxième électrode (22, 32) sont déposées sur la couche isolante (36) et/ou une étape de recuit de type firing dans un four à passage à lampes infra-rouge, à une température comprise entre 650°C et 850°C pendant une durée comprise entre 1 seconde et 3 minutes, cela étant particulièrement avantageux lorsque la différence de potentiel électrique a été appliquée alors qu'au moins une couche isolante était présente entre une des électrodes et la plaquette.

**13.** Procédé selon la revendication 11, comportant une étape de dépôt d'une troisième électrode (52) du même côté que les première et deuxième électrodes (22, 32), la troisième électrode (52) étant disjointe des première et deuxième électrodes (22, 32), la troisième électrode (52) se superposant aux zones (12) fortement dopées $n^+$ lorsque les première et deuxième électrodes (22, 32) se superposent aux zones (14) fortement dopées $p^+$, et aux zones (14) fortement dopées $p^+$ lorsque les première et deuxième électrodes (22, 32) se superposent aux zones (12) fortement dopées $n^+$, de préférence les première, deuxième et troisième électrodes (22, 32, 52) présentant une pluralité de pistes (24, 34, 54), les première et deuxième électrodes (22, 32) présentant des pistes (24, 34) qui s'intercalent alternativement entre les pistes (54) de la troisième électrode (52), de préférence le procédé comportant une étape de jonction électrique des première et deuxième électrodes (22, 32) pour former une électrode combinée, l'électrode combinée et la troisième électrode (54) étant interdigitées.

14. Procédé selon l'une quelconque des revendications précédentes, comportant une étape de recuit de la plaquette (10), en particulier à une température comprise entre 600°C et 1300°C pendant une durée comprise entre 1s et 10 min avant un refroidissement à une vitesse de refroidissement supérieure ou égale en valeur absolue à 10 K.s$^{-1}$, l'étape de recuit ayant lieu simultanément à l'étape d'application de la différence de potentiel électrique.

15. Dispositif d'extraction d'impuretés métalliques d'une ou plusieurs plaquettes de silicium cristallin, pour mettre en oeuvre le procédé selon l'une quelconque des revendications précédentes, comportant au moins :

 - un premier conducteur (60),
 - un deuxième conducteur (70) disjoint du premier conducteur (60), et
 - un générateur de tension (80) entre les premier et deuxième conducteurs (60, 70) pour générer entre les premier et deuxième conducteurs (60, 70) une différence de potentiel électrique comprise entre 1V et 10kV,

le premier conducteur (60) étant configuré pour se superposer à la première électrode (22) et le deuxième conducteur (70) étant configuré pour se superposer à la deuxième électrode (32), de préférence le premier conducteur (60) présentant un bras conducteur (62) et le deuxième conducteur (70) présentant deux bras conducteurs (72), le bras conducteur (62) du premier conducteur (60) étant intercalé entre les bras conducteurs (72) du deuxième conducteur (70).

# Fig. 1

# Fig. 2

## Fig. 3

## Fig. 4

## Fig. 5

Fig. 6

Fig. 7

Fig. 8

## Fig. 9

## Fig. 10

## Fig. 11

62    60

82

80

Gen
V

72

XIV-XIV

10b    70

# Fig. 12

80

Gen
V

82

62    10b

72

32

10a

84

72

22    32

20a

22

20a

# Fig. 13

Fig. 14

Fig. 15

Europäisches
Patentamt

European
Patent Office

Office européen
des brevets

**RAPPORT DE RECHERCHE EUROPEENNE**

Numéro de la demande

EP 18 20 9997

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X,D | W. P. LEE ET AL: "Enhanced gettering of iron impurities in bulk silicon by using external direct current electric field", JOURNAL OF ELECTRONIC MATERIALS., vol. 34, no. 7, 1 juillet 2005 (2005-07-01), pages 25-29, XP055476741, US ISSN: 0361-5235, DOI: 10.1007/s11664-005-0101-x * page 126, colonne 2, ligne 11 - page 127, colonne 2, ligne 5; figures 1-2 * | 1-15 | INV. C30B29/06 C30B33/04 H01L21/322 |
| X | FR 2 949 607 A1 (COMMISSARIAT ENERGIE ATOMIQUE [FR]) 4 mars 2011 (2011-03-04) * page 8, ligne 4 - page 9, ligne 7; revendications 1-6 * | 1,8,9,15 | |
| X | DE 10 2011 056843 A1 (CENTROTHERM PHOTOVOLTAICS AG [DE]) 27 juin 2013 (2013-06-27) * revendications 1-7; figures 2-3 * | 15 | DOMAINES TECHNIQUES RECHERCHES (IPC) |
| A,D | WO 2013/045767 A1 (AALTO KORKEAKOULUSAEAETIOE [FI]) 4 avril 2013 (2013-04-04) * revendications 1-6; figures 1-4 * | 1-15 | C30B H01L |

Le présent rapport a été établi pour toutes les revendications

| Lieu de la recherche | Date d'achèvement de la recherche | Examinateur |
|---|---|---|
| La Haye | 18 décembre 2018 | Lavéant, Pierre |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 18 20 9997

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-12-2018

| Document brevet cité au rapport de recherche | Date de publication | Membre(s) de la famille de brevet(s) | Date de publication |
|---|---|---|---|
| FR 2949607        A1 | 04-03-2011 | FR      2949607 A1<br>WO   2011027045 A2 | 04-03-2011<br>10-03-2011 |
| DE 102011056843 A1 | 27-06-2013 | DE 102011056843 A1<br>WO   2013093604 A1 | 27-06-2013<br>27-06-2013 |
| WO 2013045767     A1 | 04-04-2013 | CN      105308757 A<br>EP      2761666 A1<br>FI      20115966 A<br>US   2014238490 A1<br>WO   2013045767 A1 | 03-02-2016<br>06-08-2014<br>31-03-2013<br>28-08-2014<br>04-04-2013 |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2007095774 B
- WO 2013045767 A
- US 5770000 A
- US 6534748 B
- WO 2007107351 A
- DE 102009059300
- FR 2949607

**Littérature non-brevet citée dans la description**

- **W.P. LEE et al.** *Journal of ELECTRONIC MATERIALS,* 2005, vol. 34 (7
- **S. DUBOIS et al.** *SolMat,* 2016